# EUROPEAN PATENT SPECIFICATION

(11) **EP 4 570 617 B1**
(45) Date of publication and mention of the grant of the patent: **25.11.2026**
(21) Application number: 23307195.0
(22) Date of filing: 13.12.2023
(51) Int. Cl.: B61L 23/04, B61L 29/00, G01V 3/08, G01V 3/10, G01V 13/00, G08G 1/042

(54) **DETECTION METHOD FOR DETECTING A VEHICLE WITHIN AN AREA**
DETEKTIONSVERFAHREN ZUR DETEKTION EINES FAHRZEUGS INNERHALB EINES BEREICHS
PROCÉDÉ DE DÉTECTION POUR DÉTECTER UN VÉHICULE DANS UNE ZONE

(43) Date of publication of application: 18.06.2025
(73) Proprietor: ALSTOM Holdings, 93400 Saint-Ouen-sur-Seine (FR)
(72) Inventor: PASQUALIS, Andrea, 50013 Campi Bisenzio (FI) (IT); POZZI, Lorenzo, 59015 Carmignano (PO) (IT); CARPINETI, Federico, 56020 Santa Maria a Monte (PI) (IT); NANNUCCI, Andrea, 50143 Firenze (IT)
(74) Representative: Plasseraud IP

(56) References cited:
- JP-A- 2008 232 999
- JP-A- H03 239 987
- US-A1- 2012 286 103
- US-A1- 2014 339 374
- US-A1- 2017 054 333

## Description

The present invention relates to a detection method for detecting a vehicle within an area, using an inductive loop detection system.

Preferentially, the area is a railroad crossing. The detection system is intended to detect the presence and/or the passage of vehicles on a well delimited crossing area. Such an application needs a high safety level, ensuring that all vehicles are always detected correctly, in particular before a railway vehicle comes on the crossing.

The invention is intended to ensure a Safety Integrity Level 4 (SIL4), which is the highest safety level as defined by the standard IEC 61508. To this end, the invention proposes a very reliable maintenance method, intended to test the inductive loop detection system and to recalibrate it in case of default.

Besides, the invention proposes reaching a SIL4 while keeping a system simple and reliable.

To this end, the invention relates to a detection method for detecting vehicles within an area, using an inductive loop detection system comprising:
- at least one inductive detection loop embedded in the area,
- a resonation capacitor array intended to detect vehicles thanks to a change in the inductance of at least a loop determined by conductive material of the vehicles,
characterized in that:
- the inductive loop detection system comprises at least a test inductor with a first switch for connecting the test inductor to the resonation capacitor array in place of the at least one inductive detection loop, the test inductor having a defined and known inductance, so that the effect of the test inductor on a resonance signal of the resonation capacitor array is known and is compared with a reference signal,
- in case the resonance signal is different from the reference signal, the method comprises a recalibrating step for recalibrating the resonation capacitor array.

In a resonant circuit comprising at least one vehicle detection inductive loop connected with a capacitor unit and an optional resistance unit, the amplitude response to a given driving frequency is measured in order to detect the change of the resonant frequency caused by the variation of the inductance of the inductive loop interfering with a vehicle. The setting correctness and the response of the resonant circuit is tested by connecting the test inductor in the circuit, the test inductor having a known inductance.

A non-compliant drift of the resonance signal within a certain frequency band with the inductance introduced by the test inductor indicates that the resonant circuit response is not correct and that steps has to be taken for recalibrating it.

The invention thus proposes a simple way to verify the circuit stability and to recalibrate it in case of default.

A detection method according to the invention may comprise any of the following features, taken alone or in any possible combination:
- The area is a crossroad area of a railway.
- The resonation capacitor array comprises a main capacitor, and a plurality of additional capacitors in parallel with the main capacitor, each additional capacitor being associated with a respective switch for connecting or disconnecting the corresponding additional capacitor with the resonation capacitor array.
- The resonant circuit comprises a shunt, in series with the main capacitor.
- The inductive detection loops are arranged in parallel to each other, each inductive detection loop being associated with a respective switch, so that the resonation capacitor array can be alternatively or in sequence connected to each of inductive detection loops.
- The inductive loops are connected in a galvanic isolated manner to the resonation capacitor array by means of a transformer, preferentially having loop ratio 1 to 1.
- The first switch is arranged between the resonation capacitor array and the transformer, and between the resonation capacitor array and the test inductor, so the resonation capacitor array can be connected to the transformer or to the test inductor, and a second switch is arranged between the transformer and the inductive loops, and between the transformer and the test inductor, so the transformer can be connected to the inductive loops, or to the test inductor.
- The resonant circuit is energized with a Variable Frequency Square Wave signal supplied by a H-bridge controller, by means of an H-bridge.

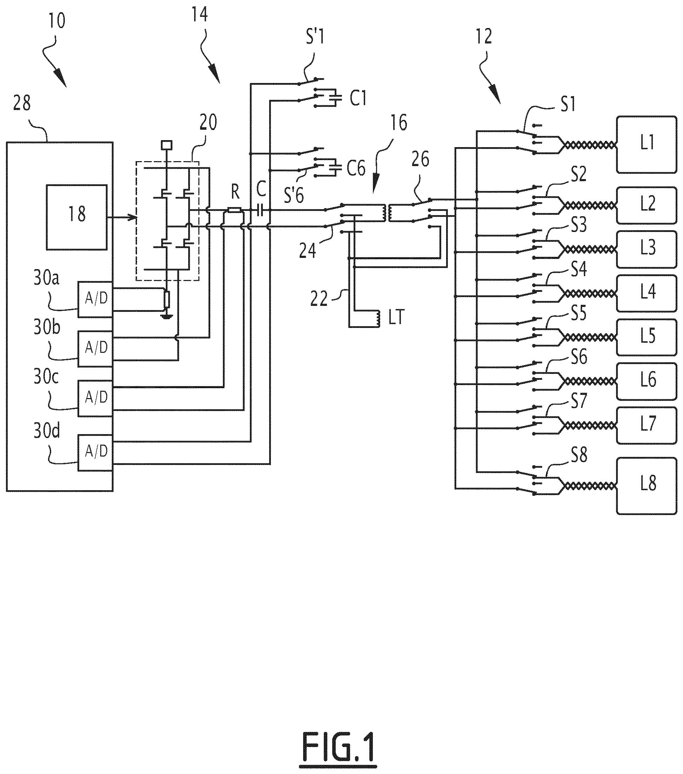

Several aspects and advantages of the invention will be enlightened in the following disclosure, only given as a non-limitative example and made in reference to attached figures, in which Figure 1 is a schematic view of an inductive loop detection system according to an example of embodiment of the invention.

Figure 1 shows an inductive loop detection system 10.

The detection system 10 is intended to detect vehicles in an area, for example a crossroad area of a railway.

The detection system 10 comprises an assembly 12 of at least one inductive detection loop embedded in the area, more particularly embedded in a road of the area. In the shown example, the detection system 10 comprises eight inductive detection loops L1...L8.

The detection system 10 also comprises a detecting circuit 14. The detecting circuit 14 is a resonation capacitor array, comprising capacitors, and connected to the assembly of inductances 12 and to a decoupling transformer 16.

The resonation capacitor array 14 comprises a main capacitor C, and preferably a plurality of additional capacitors C1...C6 in parallel with the main capacitor C. Each additional capacitor C1...C6 is associated with a respective switch S'1...S'6. So, the global capacity depends on the combination of closed switches S'1...S'6. Each capacitor C1...C6 has a typical capacitance ratio of 2 in respect to the previous one, in such a way to be connected with a binary combination in order to obtain a programmable resonation capacitor.

The resonation capacitor array 14 also comprises an optional shunt R, in series with the main capacitor C.

The inductive detection loops L1 to L8 are connected in a galvanic isolated manner to the circuit by means of the transformer 16, said transformer 16 having typical loop ratio 1 to 1.

The inductive detection loops L1...L8 are arranged in parallel to each other. Each inductive detection loop L1...L8 is associated with a respective switch S1...S8, so that the resonation capacitor array 14 can be, alternatively or in sequence, connected to each of inductive detection loops L1...L8.

The resonation capacitor array 14 is energized with a Variable Frequency Square Wave signal with a typical 50% duty cycle supplied by a H-bridge controller 18, by means of an H-bridge 20.

The voltage amplitude of the driving signal is measured across the resonation capacitance C and, optionally, the current is measured at the shunt R.

The detection system 10 of the invention is provided with at least one test inductor LT arranged in a test circuit 22.

A first switch 24 is arranged between the resonation capacitor array 14 and the transformer 16, and between the resonation capacitor array 14 and the test circuit 22, so the resonation capacitor array 14 can be connected to the transformer 16 or to the test circuit 22.

A second switch 26 is arranged between the transformer 16 and the assembly 12, and between the transformer 16 and the test circuit 22, so the transformer 16 can be connected to the inductive loop assembly 12 or to the test circuit 22.

When the first switch 24 connects the resonation capacitor array 14 with the test circuit 22, the resonation capacitor array 14 is directly connected with the test inductor LT.

When the first switch 24 connects the resonation capacitor array 14 with the transformer 16, and the second switch 26 connects the transformer 16 with the test circuit 22, the resonation capacitor array 14 is connected to the test inductor LT via the transformer 16.

The last two connection configurations allow the measure of the transformer 16 magnetizing inductance.

When the first switch 24 connects the resonation capacitor array 14 with the transformer 16, and the second switch 26 connects the transformer 16 with the assembly 12, the resonation capacitor array 14 is connected with the active inductive loop L1...L8 via the transformer 16.

The last configuration connection allows the vehicle presence detection function through the resonation capacitor array signal comparison with the signal measured in absence of vehicles.

The test inductor LT has a defined and known inductance, so the effect on the resonance signal of the capacitor array 14 is known and may be compared with a reference signal. The comparison is indicative of the correct settings or configuration or operative status of the capacitor array 14.

Different kind of tests can be carried out on the resonant circuit 12-14-16 and its components.

The variation of inductance is detected with a LC resonant circuit oscillation frequency change (ΔL/L = 2 Δf/f).

During the installation phase the board fix the bridge power supply to obtain the voltage desired value at F₀ (central Resonant Frequency).

The measured values are:
- Capacitor Voltage
- H-Bridge driving Voltage
- H-Bridge Power Supply Current
- Loop Current (optional)
- The Programmable parameters are:
- H-Bridge Voltage
- H-Bridge Frequency
- H-Bridge Duty Cycle
- Resonance Capacitor configuration (64 possible combinations with the six additional capacitors C1...C6)
- Loop number L1 to L8 or Test Inductor LT.
- The Measured parameters for temperature compensation are:
- Transformer Magnetizing Inductance
- Transformer Leakage Inductance.

In a vehicle detection configuration, the loop L1 is connected to the resonation capacitor array 14. The other loops L2...L8 are then connected in sequence, according to a predetermined scanning frequency.

Measurements are realized generating a variable frequency by a FPGA (Field Programmable Gate Array) device 28 and acquiring resonant circuit 12-14-16 voltages and currents from 16 bits A/D converters after differential analog filters and FPGA digital filters and RMS calculation.

The FPGA device 28 comprises a first converter 30a acquiring current from the bridge 20, a second converter 30b acquiring voltage from the bridge 20, a third converter 30c acquiring current from the loop and a fourth converter 30d acquiring voltage from the loop.

During installation phase, the inductive loops L1...L8 inductances are acquired by the detection system 10 (the loop transformer influence is removed from the measurement) in absence of vehicles. These measures are assured by an installation team surveillance, with a slow frequency scan allowing resonance frequency measure.

It should be noticed that the transformer 16 usually comprises a ferrite insulation, to decouple field from internal voltages in order to be insensitive to ground leakage and to reduce field common mode disturbances. However, this element is the most critical element influencing loop measures, due to ferrite material temperature variations.

This variation can be determined by connecting the test inductor LT to the transformer 16 via the second switch 26. For instance, this variation is determined every 15 minutes, and/or after each scan.

More particularly, the test inductor LT is used to determine any default in the resonation capacitor array. For stability purposes the test inductor LT can be realized with an air core. Since the test inductor LT has a defined and known inductance, the effect of the test inductor on a resonance signal of the resonant circuit 12-14-16 is known and is compared with a reference signal. In case the resonance signal is different from the reference signal, the method comprises a step for recalibrating the resonant circuit 12-14-16. For instance, the recalibration comprises changing the capacity in the resonation capacitor array 14 by connecting the appropriate capacitors C1...C6, changing the FSK frequencies, changing the H-bridge power supply voltage, changing the reference signal voltages/currents measurements or other settings or configurations.

## Claims

1. A detection method for detecting vehicles within an area, using an inductive loop detection system (10) as part of a resonant circuit (12-14-16) comprising:
- at least one inductive detection loop (L1...L8) embedded in the area,
- a resonation capacitor array (14) intended to detect vehicles thanks to a change in the inductance of at least one of the at least one inductive loop (L1....L8) determined by conductive material of the vehicles,
- a H-bridge (20),
- an H-Bridge controller (18) being part of a field programmable gate array device (28), driving the H-bridge (20) with a Variable Frequency Square Wave signal, driving H-bridge frequency and optionally driving H-bridge duty cycle, reading H-bridge (20) current and voltage and also reading H-bridge (20) power supply current, **characterized in that**:
- the inductive loop detection system (10) comprises at least a test inductor (LT) with a first switch (24) for connecting the test inductor (LT) to the resonation capacitor array (14) in place of the at least one inductive detection loop (L1...L8), the test inductor (LT) having a defined and known inductance, so that the effect of the test inductor (LT) on a resonance signal of the resonation capacitor array (14) is known and is compared with a reference signal,
- the resonation capacitor array (14) can be connected in a first configuration to each detection loop (L1...L8) and in a second configuration to the test inductor (LT), so that a change in the loop (L1... L8) resonance due to a change of the resonation capacitor array (14) will be detected with a change in the reference signal with the test inductor (LT) connected,
- in case the resonance signal is different from the reference signal with a given H-bridge (20) driving, the method comprises a recalibrating step for recalibrating the resonant circuit (12-14-16), the recalibrating step comprising either changing the capacity in the resonation capacitor array (14), in particular by connecting appropriate capacitors (C1...C6), or changing the H-bridge power supply voltage.

2. The detection method according to claim 1, wherein the area is a crossroad area of a railway.

3. The detection method according to claim 1 or 2, wherein the resonation capacitor array (14) comprises a main capacitor (C), and a plurality of additional capacitors (C1...C6) in parallel with the main capacitor (C), each additional capacitor (C1... C6) being associated with a respective switch (S'1...S'6) for connecting or disconnecting the corresponding additional capacitor (C1...C6) with the resonation capacitor array (14).

4. The detection method according to any of preceding claims, wherein the resonant circuit (12-14-16) comprises a shunt (R), in series with the main capacitor (C).

5. The detection method according to any of preceding claims, wherein the inductive detection loops (L1...L8) are electrically arranged in parallel to each other, each inductive detection loop (L1...L8) being associated with a respective switch (S1... S8), so that the resonation capacitor array (14) can be alternatively or in sequence connected to each of inductive detection loops (L1...L8).

6. The detection method according to any of preceding claims, wherein the inductive loops (L1...L8) are connected in a galvanic isolated manner to the resonation capacitor array (14) by means of a transformer (16), preferentially having turn ratio 1 to 1.

7. The detection method according to any of preceding claims, wherein the first switch (24) is arranged between the resonation capacitor array (14) and the transformer (16), and between the resonation capacitor array (14) and the test inductor (LT), so the resonation capacitor array (14) can be connected to the transformer (16) or to the test inductor (LT), and a second switch (26) is arranged between the transformer (16) and the inductive loops (L1...L8), and between the transformer (16) and the test inductor (LT), so the transformer (16) can be connected to the inductive loops (L1...L8), or to the test inductor (LT).

## Patentansprüche

1. Detektionsverfahren zum Detektieren von Fahrzeugen innerhalb eines Bereichs, wobei ein induktives Schleifen-Detektionssystem (10) als Teil eines Resonanzkreises (12-14-16) verwendet wird, welches umfasst:
- wenigstens eine induktive Detektionsschleife (L1...L8), welche in dem Bereich eingebettet ist,
- eine Resonanzkondensatoranordnung (14), welche dazu bestimmt ist, Fahrzeuge durch eine Änderung der Induktivität wenigstens einer der wenigstens einen induktiven Schleife (L1...L8) zu detektieren, welche durch leitfähiges Material der Fahrzeuge bestimmt wird,
- eine H-Brücke (20),
- eine H-Brücken-Steuerung (18), welche Teil einer Field-Programmable-Gate-Array-Vorrichtung (28) ist, welche die H-Brücke (20) mit einem Rechtecksignal mit variabler Frequenz ansteuert, die H-Brücken-Frequenz ansteuert und optional das H-Brücken-Tastverhältnis ansteuert, Strom und Spannung der H-Brücke (20) ausliest und auch den Versorgungsstrom der H-Brücke (20) ausliest,
**dadurch gekennzeichnet, dass**:
- das induktive Schleifen-Detektionssystem (10) wenigstens einen Testinduktor (LT) mit einem ersten Schalter (24) umfasst zum Verbinden des Testinduktors (LT) mit der Resonanzkondensatoranordnung (14) anstelle der wenigstens einen induktiven Detektionsschleife (L1...L8), wobei der Testinduktor (LT) eine definierte und bekannte Induktivität aufweist, sodass die Wirkung des Testinduktors (LT) auf ein Resonanzsignal der Resonanzkondensatoranordnung (14) bekannt ist und mit einem Referenzsignal verglichen wird,
- die Resonanzkondensatoranordnung (14) in einer ersten Konfiguration mit jeder Detektionsschleife (L1...L8) und in einer zweiten Konfiguration mit dem Testinduktor (LT) verbunden werden kann, sodass eine Änderung der Resonanz der Schleife (L1...L8) infolge einer Änderung der Resonanzkondensatoranordnung (14) mit einer Änderung des Referenzsignals bei angeschlossenem Testinduktor (LT) detektiert wird,
- in dem Fall, dass das Resonanzsignal bei einer gegebenen Ansteuerung der H-Brücke (20) von dem Referenzsignal verschieden ist, das Verfahren einen Rekalibrierungsschritt zum Rekalibrieren des Resonanzkreises (12-14-16) umfasst, wobei der Rekalibrierungsschritt entweder ein Ändern der Kapazität in der Resonanzkondensatoranordnung (14), insbesondere durch ein Verbinden geeigneter Kondensatoren (C1...C6), oder ein Ändern der Versorgungsspannung der H-Brücke umfasst.

2. Detektionsverfahren nach Anspruch 1, wobei der Bereich ein Kreuzungsbereich einer Eisenbahn ist.

3. Detektionsverfahren nach Anspruch 1 oder 2, wobei die Resonanzkondensatoranordnung (14) einen Hauptkondensator (C) und eine Mehrzahl von zusätzlichen Kondensatoren (C1...C6) parallel zu dem Hauptkondensator (C) umfasst, wobei jeder zusätzliche Kondensator (C1...C6) einem jeweiligen Schalter (S'1...S'6) für ein Verbinden oder Trennen des entsprechenden zusätzlichen Kondensators (C1...C6) mit beziehungsweise von der Resonanzkondensatoranordnung (14) zugeordnet ist.

4. Detektionsverfahren nach einem der vorhergehenden Ansprüche, wobei der Resonanzkreis (12-14-16) einen Shunt (R) in Reihe mit dem Hauptkondensator (C) umfasst.

5. Detektionsverfahren nach einem der vorhergehenden Ansprüche, wobei die induktiven Detektionsschleifen (L1...L8) elektrisch parallel zueinander geschaltet sind, wobei jede induktive Detektionsschleife (L1...L8) einem jeweiligen Schalter (S1...S8) zugeordnet ist, sodass die Resonanzkondensatoranordnung (14) abwechselnd oder nacheinander mit jeder der induktiven Detektionsschleifen (L1...L8) verbunden werden kann.

6. Detektionsverfahren nach einem der vorhergehenden Ansprüche, wobei die induktiven Schleifen (L1...L8) mittels eines Transformators (16), welcher vorzugsweise ein Wicklungsverhältnis 1 zu 1 aufweist, auf galvanisch isolierte Weise mit der Resonanzkondensatoranordnung (14) verbunden sind.

7. Detektionsverfahren nach einem der vorhergehenden Ansprüche, wobei der erste Schalter (24) zwischen der Resonanzkondensatoranordnung (14) und dem Transformator (16) sowie zwischen der Resonanzkondensatoranordnung (14) und dem Testinduktor (LT) angeordnet ist, sodass die Resonanzkondensatoranordnung (14) mit dem Transformator (16) oder mit dem Testinduktor (LT) verbunden werden kann, und wobei ein zweiter Schalter (26) zwischen dem Transformator (16) und den induktiven Schleifen (L1...L8) sowie zwischen dem Transformator (16) und dem Testinduktor (LT) angeordnet ist, sodass der Transformator (16) mit den induktiven Schleifen (L1...L8) oder mit dem Testinduktor (LT) verbunden werden kann.

## Revendications

1. Procédé de détection pour détecter des véhicules à l'intérieur d'une zone, à l'aide d'un système de détection à boucle inductive (10) en tant que partie d'un circuit résonnant (12-14-16) comprenant :
- au moins une boucle (L1...L8) de détection inductive encastrée dans la zone,
- un réseau de condensateurs de résonance (14) destiné à détecter des véhicules grâce à un changement d'inductance d'au moins une parmi la au moins une boucle (L1...L8) inductive déterminée par un matériau conducteur des véhicules,
- un pont en H (20),
- un dispositif de contrôle (18) de pont en H faisant partie d'un dispositif de réseau de portes programmable sur site (28), pilotant le pont en H (20) avec un signal d'onde carrée à fréquence variable, pilotant la fréquence du pont en H et optionnellement pilotant le cycle de service du pont en H, lisant le courant et la tension du pont en H (20) et lisant également le courant d'alimentation électrique du pont en H (20), **caractérisé en ce que** :
- le système de détection à boucle inductive (10) comprend au moins un inducteur d'essai (LT) avec un premier commutateur (24) pour connecter l'inducteur d'essai (LT) au réseau de condensateurs de résonance (14) à la place de la au moins une boucle (L1...L8) de détection inductive, l'inducteur d'essai (LT) ayant une inductance définie et connue, de façon à ce que l'effet de l'inducteur d'essai (LT) sur un signal de résonance du réseau de condensateurs de résonance (14) soit connu et soit comparé à un signal de référence,
- le réseau de condensateurs de résonance (14) peut être connecté dans une première configuration à chaque boucle (L1...L8) de détection et dans une seconde configuration à l'inducteur d'essai (LT), de façon à ce qu'un changement dans la résonance de boucle (L1...L8) en raison d'un changement du réseau de condensateurs de résonance (14) soit détecté avec un changement de signal de référence avec l'inducteur d'essai (LT) connecté,
- dans le cas où le signal de résonance est différent du signal de référence avec un pilotage du pont en H (20) donné, le procédé comprend une étape de réétalonnage pour réétalonner le circuit résonnant (12-14-16), l'étape de réétalonnage comprenant soit le changement de capacité dans le réseau de condensateurs de résonance (14), en particulier en connectant des condensateurs (C1...C6) appropriés, soit le changement de tension d'alimentation électrique du pont en H.

2. Procédé de détection selon la revendication 1, dans lequel la zone est une zone de carrefour d'une voie ferrée.

3. Procédé de détection selon la revendication 1 ou 2, dans lequel le réseau de condensateurs de résonance (14) comprend un condensateur principal (C), et une pluralité de condensateurs supplémentaires (C1...C6) en parallèle avec le condensateur principal (C), chaque condensateur supplémentaire (C1...C6) étant associé à un commutateur (S'1...S'6) respectif pour connecter ou déconnecter le condensateur supplémentaire (C1...C6) correspondant au/du réseau de condensateurs de résonance (14).

4. Procédé de détection selon l'une quelconque des revendications précédentes, dans lequel le circuit résonnant (12-14-16) comprend un shunt (R), en série avec le condensateur principal (C).

5. Procédé de détection selon l'une quelconque des revendications précédentes, dans lequel les boucles (L1...L8) de détection inductives sont agencées électriquement en parallèle les unes par rapport aux autres, chaque boucle (L1...L8) de détection inductive étant associée à un commutateur (S1...S8) respectif, de façon à ce que le réseau de condensateurs de résonance (14) puisse être connecté alternativement ou de manière séquentielle à chacune des boucles (L1...L8) de détection inductives.

6. Procédé de détection selon l'une quelconque des revendications précédentes, dans lequel les boucles (L1...L8) inductives sont connectées de manière isolée galvaniquement au réseau de condensateurs de résonance (14) au moyen d'un transformateur (16), de préférence ayant un rapport de transformation 1 à 1.

7. Procédé de détection selon l'une quelconque des revendications précédentes, dans lequel le premier commutateur (24) est agencé entre le réseau de condensateurs de résonance (14) et le transformateur (16), et entre le réseau de condensateurs de résonance (14) et l'inducteur d'essai (LT), de façon à ce que le réseau de condensateurs de résonance (14) puisse être connecté au transformateur (16) ou à l'inducteur d'essai (LT), et un second commutateur (26) est agencé entre le transformateur (16) et les boucles (L1...L8) inductives, et entre le transformateur (16) et l'inducteur d'essai (LT), de façon à ce que le transformateur (16) puisse être connecté aux boucles (L1...L8) inductives, ou à l'inducteur d'essai (LT).
